(19) Europäisches Patentamt / European Patent Office / Office européen des brevets

(11) **EP 2 411 825 B1**

(12) **FASCICULE DE BREVET EUROPEEN**

(45) Date de publication et mention
de la délivrance du brevet:
**18.12.2013 Bulletin 2013/51**

(21) Numéro de dépôt: **10715976.6**

(22) Date de dépôt: **25.03.2010**

(51) Int Cl.:
***G01R 33/04*** *(2006.01)*

(86) Numéro de dépôt international:
**PCT/FR2010/050537**

(87) Numéro de publication internationale:
**WO 2010/109138 (30.09.2010 Gazette 2010/39)**

(54) **DISPOSITIF POUR DETECTER ET/OU MESURER UN CHAMP MAGNETIQUE FAIBLE**

VORRICHTUNG ZUM DETEKTIEREN UND/ODER MESSEN EINES SCHWACHEN MAGNETFELDES

DEVICE FOR DETECTING AND/ORD MEASURING A SMALL MAGNETIC FIELD

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **25.03.2009 FR 0951918**

(43) Date de publication de la demande:
**01.02.2012 Bulletin 2012/05**

(73) Titulaire: **Centre National de la Recherche Scientifique**
**75016 Paris (FR)**

(72) Inventeur: **CAVOIT, Claude**
**F-58320 Parigny Les Vaux (FR)**

(74) Mandataire: **Pontet Allano & Associes**
**Parc Orsay Université**
**25, rue Jean-Rostand**
**91893 Orsay Cedex (FR)**

(56) Documents cités:
**EP-A2- 1 813 953     WO-A1-2008/016198**
**FR-A1- 2 860 594     US-A1- 2005 035 761**

- **CAVOIT CLAUDE: "Closed loop applied to magnetic measurements in the range of 0.1-50MHz" REVIEW OF SCIENTIFIC INSTRUMENTS, AIP, MELVILLE, NY, US, vol. 77, no. 6, 27 juin 2006 (2006-06-27), pages 64703-064703, XP012093128 ISSN: 0034-6748**
- **wikipedia: "Spacecraft Magnetometer" 15 février 2009 (2009-02-15), XP002566372 Extrait de l'Internet: URL:http://en.wikipedia.org/w/index.php?ti tle=Spacecraft_magnetometer&oldid=27091431 0>**

EP 2 411 825 B1

## Description

## Domaine technique

La présente invention concerne un dispositif pour détecter et/ou mesurer un champ magnétique faible. Elle concerne également un système mettant en oeuvre un tel dispositif.

Le domaine de l'invention est de manière générale la détection et/ou la mesure d'un champ magnétique faible, et plus particulièrement, la détection et la mesure du champ magnétique des planètes, du champ magnétique en forage géophysique, ainsi que celui de la prospection géophysique par méthodes électromagnétiques, du contrôle non destructif de structures métalliques par méthodes électromagnétiques.

## Etat de la technique antérieure

On connaît dans l'art antérieur différents dispositifs pour mesurer un champ magnétique.

Les fluxgates en particulier comprennent un noyau torique autour duquel est placé un enroulement d'excitation alimenté par un courant alternatif et qui créé un champ magnétique excitateur circulant autour du tore. Ce champ magnétique provoque alors une saturation périodique, alternativement dans un sens puis dans l'autre, du matériau magnétique du noyau torique. Un champ à mesurer vient alors s'additionner à ce phénomène de saturation périodique, ce qui provoque un déséquilibre entre le passage à saturation lorsque le champ à mesurer s'additionne au champ magnétique excitateur, et le passage à saturation lorsque le champ à mesurer se retranche du champ magnétique excitateur. L'inconvénient des fluxgates est leur encombrement et leur masse.

On connaît par exemple le document US 2005/0035761 A1, qui divulgue un capteur de type « fluxgate », intégré dans un substrat semiconducteur. On connaît également le document WO 2008/016198 A1, divulguant un autre exemple de fluxgate. Enfin, le document FR 2 860 594 divulgue un magnétomètre avec deux branches chacune entourée par un bobinage d'excitation qui dépasse des extrémités du noyau magnétique de façon que le noyau magnétique soit saturé jusque dans ses extrémités et se trouve dans une zone de champ magnétique constant.

D'autres dispositifs mettent en oeuvre des magnétorésistances géantes (ou GMR pour l'anglais Giant MagnetoResistance). Une magnétorésistance géante est composée d'une alternance de couches ultra minces de matériaux ferromagnétiques et de matériaux non magnétiques. Un champ magnétique externe oriente l'aimantation de toutes les couches dans sa propre direction, réduisant ainsi fortement la résistance de ladite magnétorésistance géante. Il est donc possible, en suivant l'évolution de la résistance de la magnétorésistance géante, de suivre l'évolution d'un champ magnétique externe. L'avantage des dispositifs à magnétorésistance géante réside dans leur faible encombrement et leur masse réduite. Cependant, ce type de capteur soufre aussi de nombreuses limitations :

- il présente un bruit de fond en $\dfrac{1}{f}$, ce qui rend sa sensibilité médiocre aux basses fréquences, en particulier dans la gamme du Hertz et en-dessous, c'est-à-dire pour un champ magnétique alternatif de fréquence réduite et à plus forte raison pour un champ magnétique continu ;
- il présente une forte dépendance à la température ;
- il présente un offset important ; et
- il nécessite une polarisation magnétique dont la stabilité conditionne la sensibilité.

Le but de la présente invention est de proposer un dispositif et un système pour détecter et/ou mesurer un champ magnétique faible, qui atténue les limitations énoncées ci-avant.

Un autre but de la présente invention est de proposer un dispositif et un système pour détecter et/ou mesurer un champ magnétique faible, de faible encombrement et plus sensible dans toute la bande de fréquence.

Encore un but de la présente invention est de proposer un dispositif et un système pour détecter et/ou mesurer un champ magnétique faible, de faible encombrement présentant de meilleures performances pour un champ magnétique alternatif ou continu.

Il est un autre but de la présente invention de proposer un dispositif et un système pour détecter et/ou mesurer un champ magnétique faible, de faible encombrement et présentant une dépendance à la température moins importante que les dispositifs et systèmes de l'état de la technique.

Il est aussi un but de la présente invention de proposer un dispositif et un système pour détecter et/ou mesurer un champ magnétique faible, de faible encombrement et présentant un offset moins important que les dispositifs et systèmes de l'état de la technique.

Enfin, il est un but de la présente invention de proposer un dispositif et un système pour détecter et/ou mesurer un champ magnétique faible, de faible encombrement et dans lesquels la stabilité d'une polarisation magnétique ne conditionne pas la sensibilité.

## Exposé de l'invention

Cet objectif est atteint avec un dispositif pour détecter et/ou mesurer un champ magnétique faible, comprenant au moins deux branches composées d'un matériau ferromagnétique, sensiblement parallèles entre elles selon leur plus grande dimension, chacune desdites branches étant munie de moyens pour détecter et/ou mesurer un champ magnétique, et parcourue par un flux magnétique de polarisation de sorte qu'au moins deux desdites branches sont de polarisations de signes opposés et où au moins une des branches est munie d'au moins un entrefer où sont agencés des moyens pour mesurer un champ magnétique.

On parlera dans la suite simplement de moyens pour mesurer un champ magnétique.

On appelle champ magnétique faible, un champ magnétique allant de l'ordre du milliTesla (mT) à l'ordre du femtoTesla (fT).

Le matériau ferromagnétique composant les deux branches présente une forte perméabilité magnétique et comprend de préférence de la ferrite, et/ou un alliage magnétique tel qu'un alliage de fer et de nickel comme le NiFe. On peut aussi utiliser du cobalt, certains terres rares tels que les Lanthanides, ainsi que certains alliages tels que l'alliage d'Heussler (61%Cu, 24%Mn, 15%Al).

Les au moins deux branches sont en outre parallèles entre elles selon leur plus grande dimension, ce qui permet de concentrer un flux magnétique le long desdites branches. Le dispositif formé par lesdites au moins deux branches agit alors comme un circuit amplificateur d'un champ magnétique, en particulier pour amplifier le champ magnétique à mesurer. Plus les branches sont longues, plus le flux magnétique est concentré le long de ces branches. L'amplification du champ magnétique à mesurer permet d'augmenter la sensibilité du dispositif pour détecter et/ou mesurer un champ magnétique faible, ou en d'autres termes d'augmenter le rapport signal sur bruit du dispositif pour détecter et/ou mesurer un champ magnétique faible.

Chacune desdites branches est munie de moyens pour mesurer un champ magnétique. Or, en première approximation, en mesurant le champ magnétique à l'aide de N moyens pour mesurer un champ magnétique, on multiplie le signal mesuré par N alors que le bruit associé audit signal n'est multiplié que par $\sqrt{N}$. Ainsi, le rapport signal sur bruit du dispositif pour détecter et/ou mesurer un champ magnétique faible est multiplié par $\sqrt{N}$.

Un champ magnétique de polarisation permet d'amener les moyens pour mesurer un champ magnétique à un point de fonctionnement désiré, et idéalement optimal. A un flux magnétique, par exemple le flux magnétique de polarisation, correspond un champ magnétique, par exemple le champ magnétique de polarisation. Le flux magnétique correspond à ce qui parcourt un matériau, tandis que le champ magnétique est présent en dehors dudit matériau. Le champ magnétique de polarisation est généralement largement plus intense que le champ magnétique à mesurer. Le point de fonctionnement optimal est tel que pour une faible variation d'un champ magnétique auquel sont soumis les moyens pour mesurer un champ magnétique, on mesure une forte variation de la réponse au champ magnétique desdits moyens. Le champ magnétique de polarisation est donc mesuré par les moyens pour mesurer un champ magnétique, en même temps que le champ magnétique à mesurer. La stabilité de la mesure du champ magnétique à mesurer dépend donc directement de la stabilité du champ magnétique de polarisation. Soit N supérieur ou égal à deux, en mesurant la somme des signaux délivrés par chacun des N moyens pour mesurer un champ magnétique, on obtient N mesures correspondant au champ magnétique à mesurer, et N mesures correspondant aux champs magnétiques de polarisation. On parle de plusieurs champs magnétiques de polarisation, et de mesures correspondant au champ magnétique à mesurer, car à un flux magnétique correspond un champ magnétique, le flux magnétique étant lui-même fonction notamment de la dimension de la branche sur laquelle se trouvent les moyens pour mesurer un champ magnétique. On ne mesure donc pas forcement sur chacune des branches les même champs magnétiques de polarisation et à mesurer.

Au moins deux des branches formant le circuit de polarisation sont de polarisations de signes opposés. Lesdites deux branches sont donc parcourues par des flux magnétiques de polarisation de sens opposés. On peut dire aussi que l'on fait apparaître en mode commun un champ magnétique de polarisation et les défauts qui y sont associés. Ainsi, en mesurant un signal de sortie correspondant à la somme des signaux délivrés sur chacune des branches, au moins une mesure d'un champ magnétique de polarisation correspondant à un flux magnétique de polarisation circulant dans un sens donné, se soustrait au lieu de s'additionner à l'au moins une autre mesure d'un champ magnétique de polarisation correspondant à un flux magnétique de polarisation circulant dans le sens opposé. Ainsi, l'influence de la polarisation magnétique sur la mesure du champ magnétique à mesurer, et l'influence de l'instabilité de cette polarisation, sont nettement diminués.

Selon l'invention, au moins une des branches est munie d'au moins un entrefer où sont agencés des moyens pour mesurer un champ magnétique. En effet, la concentration d'un flux magnétique dans une branche comprenant un entrefer permet d'obtenir dans ledit entrefer un champ magnétique amplifié. Le champ magnétique dans un entrefer est fonction notamment du flux dans la branche comportant cet entrefer, à proximité de celui-ci, et de la largeur de l'entrefer. De préférence, la largeur de l'entrefer est réduite. Plus l'entrefer est large, moins le champ magnétique à l'intérieur de cet entrefer est intense. De préférence, chaque branche comprend un entrefer où sont agencés les moyens pour mesurer un champ magnétique correspondants à cette branche, et cet entrefer est de même largeur pour chacune des branches.

De préférence, le dispositif pour détecter et/ou mesurer un champ magnétique forme au moins une boucle fermée pour le flux magnétique de polarisation total.

Le flux magnétique de polarisation total comprend l'ensemble des flux de polarisation magnétique sur chacune des branches. L'au moins une boucle constitue un circuit de polarisation. Le circuit de polarisation est formé par les branches sensiblement parallèles entre elles selon leur plus grande dimension et reliées entre elles à leurs deux extrémités, de chaque côté par une base commune. Les extrémités des branches sont définies ici comme les extrémités opposées des branches considérées selon leur plus grande dimension. Toutes les branches ont donc de préférence sensiblement la même longueur, leur longueur correspondant à leur plus grande dimension. Le flux magnétique de polarisation total circule en boucle le long du circuit de polarisation en passant dans un sens par au moins une branche dite branche de polarisation positive, et dans l'autre sens par au moins une branche dite branche de polarisation négative.

Selon un mode de réalisation privilégié, le flux magnétique de polarisation total peut se répartir à parts sensiblement égales entre l'au moins une branche de polarisation positive et l'au moins une branche de polarisation négative.

De préférence, la somme des champs magnétiques de polarisation d'amplitude positive mesurés est sensiblement égale à la somme des champs magnétiques de polarisation d'amplitude négative mesurés. On peut donc aussi avantageusement prendre en compte l'emplacement des moyens pour mesurer un champ magnétique à l'intérieur ou non d'un entrefer, et dans le cas où ceux-ci sont dans un entrefer, la géométrie et la largeur dudit entrefer.

Dans la pratique, on peut étalonner chaque branche et affecter à chacune d'elle un coefficient qui prendra en compte en particulier la section de la branche, la sensibilité des moyens pour mesurer un champ magnétique, les dimensions de l'entrefer. Ensuite, on utilisera les signaux issus de chacune des branches en les pondérant par lesdits coefficients.

De préférence, les moyens pour mesurer un champ magnétique appartenant à chacune des branches peuvent présenter les mêmes caractéristiques. En particulier, ils présentent la même sensibilité S. Ainsi, si sur chaque branche les moyens pour mesurer un champ magnétique sont soumis à des champs magnétiques sensiblement identiques, les moyens pour mesurer un champ magnétique appartenant à chacune des branches vont délivrer le même signal de sortie.

Selon un mode de réalisation privilégié, les moyens pour mesurer un champ magnétique appartenant à chacune des branches peuvent être à réponse sensiblement unipolaire. On entend par réponse unipolaire que lesdits moyens présentent la même réponse à un champ magnétique d'amplitude donnée, qu'il soit positif ou négatif. Ainsi pour des branches sans entrefer, si le flux magnétique de polarisation total correspondant au champ magnétique de polarisation total, se répartit à parts sensiblement égales entre l'au moins une branche de polarisation positive et l'au moins une branche de polarisation négative et que les moyens pour mesurer un champ magnétique appartenant à chacune des branches présentent les mêmes caractéristiques, et en particulier la même sensibilité, et sont à réponse unipolaire, alors en mesurant le signal de sortie correspondant à la somme des signaux délivrés sur chacune des branches, le signal correspondant au champ magnétique de polarisation total se compense en totalité. Pour des branches comprenant des entrefers dans lesquels sont placés des moyens pour mesurer un champ magnétique, il faut aussi prendre en compte en particulier la largeur de chaque entrefer de façon que la somme des champs magnétiques de polarisation d'amplitude positive mesurés soit sensiblement égale à la somme des champs magnétiques de polarisation d'amplitude négative mesurés. On s'affranchit alors totalement des instabilités et autres défauts apportés par le champ magnétique de polarisation sur la précision et la stabilité de la mesure du champ magnétique à mesurer. Dans la pratique, on n'obtient pas une compensation parfaite. On atteint par exemple une compensation totale à 5% près.

Le dispositif pour détecter et/ou mesurer un champ magnétique faible peut comprendre, de préférence, un nombre pair de branches de même section, ayant des polarisations de même amplitude et opposées deux à deux. En effet, le flux magnétique de polarisation traversant une branche dépend notamment de la section de la branche. La section de la branche correspond à la section perpendiculaire à la direction de propagation dudit flux. On considère donc de préférence la section perpendiculaire à la plus grande dimension de la branche. En outre, la section de la branche est avantageusement la même sur toute la longueur de la branche. Grâce à des branches de même section, si la moitié des branches est parcourue par un flux magnétique de polarisation orienté dans un sens donné, et l'autre moitié des branches est parcourue par un flux magnétique de polarisation de même amplitude et orienté dans l'autre sens, alors le flux correspondant au champ magnétique de polarisation total se répartit à parts égales entre l'au moins une branche de polarisation positive et l'au moins une branche de polarisation négative. Il suffit en général que les sections des branches soient les même uniquement à proximité des moyens pour mesurer un champ magnétique. Avantageusement, les branches peuvent comprendre en outre des entrefers de même largeur où sont agencés des moyens pour mesurer un champ magnétique.

Les moyens pour mesurer un champ magnétique peuvent comprendre au moins un composant dont la résistance dépend du champ magnétique auquel il est soumis.

Selon un autre mode de réalisation, les moyens pour mesurer un champ magnétique peuvent comprendre au moins un composant dont l'inductance dépend du champ magnétique auquel il est soumis.

Les moyens pour mesurer un champ magnétique peuvent être parcourus par un courant électrique, soit en les alimentant avec une différence de potentiel fixe, soit en les alimentant avec un courant fixe. On note ici que le terme « fixe » n'est pas à confondre avec le terme « continu ». Avantageusement, le courant électrique parcourant les moyens pour mesurer un champ magnétique est un courant alternatif. On peut donc mesurer la résistance et/ou l'inductance de l'au moins un composant, et en déduire la valeur du champ magnétique auquel le composant est soumis.

Selon un mode de réalisation privilégié, l'au moins un composant peut comprendre au moins une magnétorésistance géante, ou une magnétorésistance à effet tunnel, ou une magnétorésistance géante anisotropique, qui sont des composants dont la résistance dépend du champ magnétique auquel il est soumis.

Les moyens pour mesurer un champ magnétique peuvent comprendre de préférence au moins deux composants, au moins l'un desdits composants étant isolé de tout champ magnétique par un blindage, et au moins l'un desdits composants étant soumis à tout champ magnétique. L'isolation par un blindage n'est pas forcement parfaite. Elle est réalisée par exemple grâce à une couche de NiFe, qui peut servir alors en même temps de concentrateur de flux pour tout champ magnétique, auquel au moins un composant est soumis. Si plusieurs composants sont soumis à tout champ magnétique, ceux-ci présentent avantageusement les mêmes caractéristiques, en particulier la même sensibilité. Les plusieurs composants sont en outre avantageusement unipolaires.

De préférence, tous les composants présentent les mêmes caractéristiques, en particulier la même sensibilité.

Selon un mode de réalisation particulier, les moyens pour mesurer un champ magnétique comprennent quatre composants montés en pont de Wheatstone, au moins l'un desdits composants étant isolé de tout champ magnétique par un blindage, et au moins l'un desdits composants étant soumis à tout champ magnétique. Puisque l'on connaît la valeur de la résistance et/ou inductance de l'au moins un composant isolé de tout champ magnétique, on retrouve facilement la valeur de la résistance et/ou inductance de l'au moins un composant soumis à tout champ magnétique, sous réserve que si plusieurs composants sont soumis au champ magnétique, ceux-ci aient la même réponse en résistance et/ou inductance en fonction du champ magnétique. L'avantage d'une telle configuration est que l'on mesure un champ magnétique grâce à la mesure d'une tension entre deux bornes présentant une faible différence de potentiel. De préférence, deux composants sont isolés par un blindage et deux composants sont soumis à tout champ magnétique. De préférence, les quatre composants sont identiques.

Des moyens de polarisation induisent le flux magnétique de polarisation. Ils comprennent de préférence au moins un élément parmi une bobine et un aimant permanent. L'au moins une bobine ou aimant permanent appartient de préférence à l'une des deux bases communes qui permet de fermer le circuit de polarisation en boucle. Selon une variante, au moins une bobine ou aimant permanent est agencé sur chacune des branches du dispositif. Selon une autre variante, l'au moins une bobine ou aimant permanent forme à lui seul au moins l'une desdites deux bases communes. De préférence, il existe deux bobines ou aimants permanents appartenant à et/ou formant respectivement l'une et l'autre des deux bases communes du circuit de polarisation. Sur chaque base commune, il peut se trouver plusieurs bobines ou aimant permanents montés en série. De préférence, les moyens de polarisation sont répartis à parts égales entre les deux bases communes. Afin que l'au moins une bobine ou aimant permanent génère le champ magnétique de polarisation, celui-ci est alimenté en série par un courant électrique dit courant de polarisation. Dans le cas d'un courant de polarisation continu, la réponse d'une magnétorésistance géante présente un hystérésis qui peut être réduit par un courant de polarisation alternatif. On parle d'hystérésis car, en relevant l'évolution de la résistance de ladite magnétorésistance géante en faisant croître, puis décroître, le champ magnétique auquel elle est soumise, on obtient une courbe croissante et une courbe décroissante qui ne sont pas superposées. Dans le cas d'un courant de polarisation alternatif, le bruit de fond est cependant plus important qu'en polarisation continue. La densité spectrale du bruit de fond est par exemple de $1 \ nT/\sqrt{Hz}$ à 1Hz, où 1Hz est une fréquence comprise dans la bande passante. Ce que l'on appelle bruit de fond est le signal de sortie mesuré en l'absence de signal d'entrée, c'est à dire ici en l'absence de champ magnétique à mesurer.

Chaque branche comprend, selon un mode de réalisation privilégié, au moins une contre-réaction. La contre-réaction est réalisée de préférence par une bobine qui créé un champ de contre-réaction axial selon l'axe des branches. La contre-réaction agit avantageusement au niveau d'un entrefer, là où sont placés les moyens pour mesurer un champ magnétique, pour s'opposer au champ magnétique amplifié au niveau d'un entrefer. Selon un mode de réalisation avantageux, chaque branche comprend une contre-réaction placée au plus près des moyens pour mesurer un champ magnétique. Chaque contre-réaction est alors alimentée par un courant électrique issu de la sortie d'une électronique d'amplification du signal produit par les moyens pour mesurer un champ magnétique.

De préférence, chacune des branches comprend le même nombre de contre-réactions.

L'au moins une contre réaction permet de limiter la non-linéarité, l'hystérésis et également la sensibilité à la température, des moyens pour mesurer un champ magnétique et en particulier des magnétorésistances géantes.

Selon un autre aspect de l'invention il est proposé un système pour détecter et/ou mesurer un champ magnétique faible comprenant deux dispositifs selon l'invention, disposés selon deux axes formant une base d'un plan. Ainsi, il est possible de mesurer deux composantes selon lesdits deux axes, d'un champ magnétique à mesurer, de façon à retrouver la valeur dudit champ magnétique dans le plan ayant comme base lesdits deux axes.

Le système selon l'invention peut aussi comprendre trois dispositifs tels que décrits précédemment, disposés selon trois axes formant une base d'un espace en trois dimensions. Ainsi, il est possible de mesurer trois composantes selon lesdits trois axes, d'un champ magnétique à mesurer, de façon à retrouver la valeur dudit champ magnétique selon l'espace en trois dimensions ayant comme base lesdits trois axes.

Le dispositif et le système selon l'invention sont utilisés pour détecter et/ou mesurer un champ magnétique faible dans divers domaines tels que le contrôle non destructif de structures conductrices. La mesure de champs magnétique faibles sert aussi pour effectuer des mesures magnétiques en forage géophysique, des mesures de prospection géophysique par méthode électromagnétique, pour contrôler un système, dans un moteur, et dans des équipements embarqués dans l'automobile et l'aéronautique.

Le dispositif et le système selon l'invention peuvent en outre être destinés à la mesure d'un champ magnétique faible appliqué au secteur spatial. On mesure en particulier le champ magnétique d'une planète au sol ou à bord de satellites. En effet, la mesure des champs magnétiques faibles à bord d'un satellite ne peut être réalisée dans de bonnes conditions qu'en éloignant suffisamment le capteur du corps du satellite. Le corps constitue en effet une source de perturbations importantes, du fait de la diversité des équipements électroniques qu'il abrite. On éloigne ledit capteur par exemple en le montant sur un bras. Notamment dans un souci d'économie d'énergie, il apparaît alors très avantageux d'utiliser un dispositif et/ou un système présentant une masse et un encombrement réduits. Or, le dispositif et le système présentent l'avantage, outre une complexité d'utilisation réduite, de présenter une masse et un encombrement faibles. Un autre avantage conféré par le faible encombrement du dispositif selon l'invention est sa très bonne résolution spatiale, liée à sa taille réduite.

Le dispositif selon l'invention est particulièrement adapté à la mesure de champs magnétiques faibles continus ou variables de basse fréquence, c'est-à-dire comprise entre 1Hz et quelques centaines de kHz, allant jusqu'à un MHz.

Le dispositif présente des capacités de miniaturisation très importantes, puisqu'il est possible de développer sur une même puce par exemple de silicium toutes les fonctions : mesure d'un champ magnétique, concentrateur de flux, génération d'un champ magnétique de polarisation, et conditionnement du signal.

**Description des figures et modes de réalisation**

D'autres avantages et particularités de l'invention apparaîtront à la lecture de la description détaillée de mises en oeuvre et de modes de réalisation nullement limitatifs, et des dessins annexés suivants :

- la figure 1 illustre un schéma de principe d'un dispositif selon l'invention,
- la figure 2 est une courbe représentant la réponse d'une magnétorésistance géante en fonction du champ magnétique auquel elle est soumise,
- la figure 3 illustre un mode de réalisation de moyens pour mesurer un champ magnétique mis en oeuvre dans un dispositif selon l'invention,
- la figure 4 illustre un premier mode de réalisation d'un dispositif selon l'invention,
- la figure 5 illustre un deuxième mode de réalisation d'un dispositif selon l'invention, et
- la figure 6 illustre un mode de réalisation d'un système comprenant trois dispositifs disposés selon trois axes formant une base d'un espace en trois dimensions.

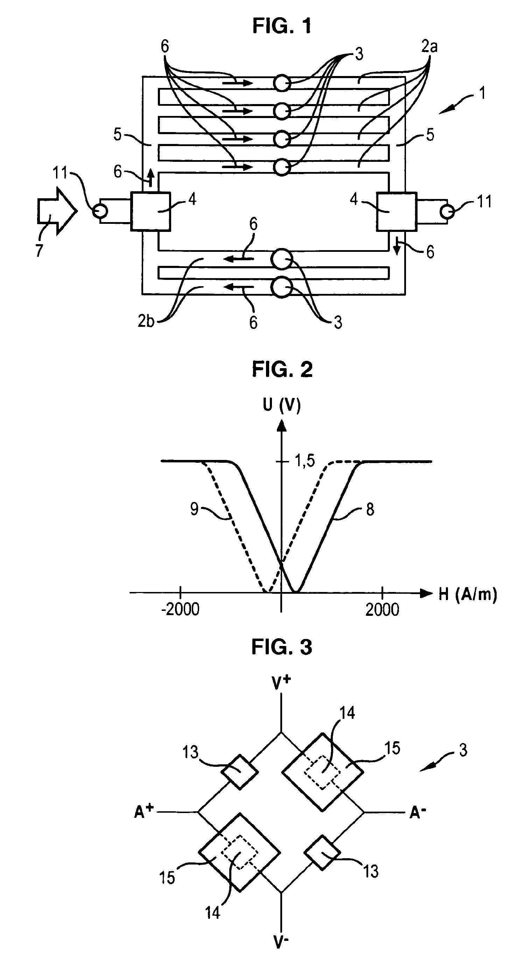

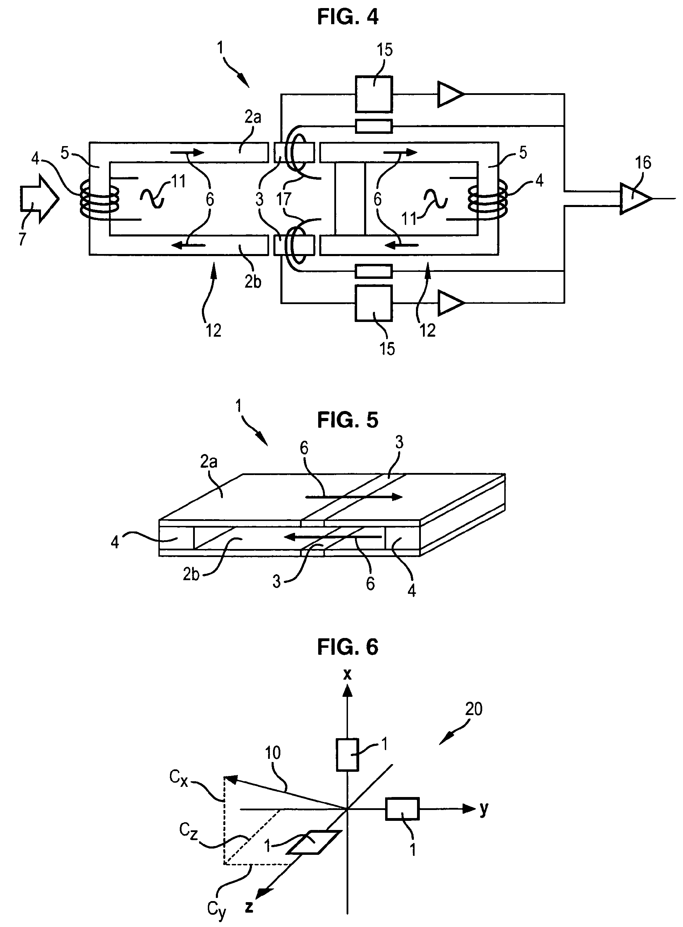

La figure 1 présente un schéma de principe d'un dispositif 1 selon l'invention comprenant plusieurs branches 2a et 2b composées d'un matériau ferromagnétique en ferrite. Les branches 2a et 2b sont sensiblement parallèles entre elles selon leur plus grande dimension, et munies de moyens 3 pour mesurer un champ magnétique. Le champ magnétique à mesurer 10 est représenté par une flèche à la figure 6.

Les moyens 3 pour mesurer un champ magnétique sont formées chacun par au moins un composant dont la résistance et/ou l'inductance varie avec le champ magnétique auquel il est soumis. Ici on utilise des magnétorésistances géantes. Des moyens de polarisation 4 induisent des flux de polarisation 6, le flux de polarisation total circulant en boucle le long des branches 2a et 2b. Les branches 2a et 2b sont reliées entre elles à leurs extrémités respectives par une base 5 commune qui comprend les moyens de polarisation 4. Les moyens de polarisation 4 sont reliés à une alimentation 11. Dans un sens, puis dans l'autre le flux magnétique de polarisation total se répartit entre toutes les branches de polarisation positive 2a pour un sens, et entre toutes les branches de polarisation négative 2b pour l'autre sens. Les moyens de polarisation 4 sont situés à la fois sur la base 5 commune et entre les branches de polarisation positive 2a et les branches de polarisation négative 2b. Le dispositif 1 permet de mesurer une composante 7 du champ magnétique à mesurer 10, ladite composante 7 étant la projection sur une droite parallèle aux branches 2a et 2b du champ magnétique à mesurer 10.

La figure 2 illustre la réponse d'une magnétorésistance géante en fonction du champ magnétique auquel elle est soumise. L'axe des abscisses correspond au champ magnétique auquel la magnétorésistance est soumise, en A/m, et l'axe des ordonnées correspond à une mesure de tension en Volt, qui dépend de la résistance de la magnétorésistance géante. La courbe 8 correspond à une mesure en faisant évoluer le champ magnétique dans un sens, croissant ou décroissant, tandis que la courbe 9 correspond à une mesure en faisant évoluer le champ magnétique dans l'autre sens. Les deux courbes 8 et 9 ne sont pas superposées, ce qui est le signe d'un hystérésis. Cet hystérésis est exagéré sur la figure 2 pour pouvoir être mieux mis en évidence. On remarque de plus la réponse de la magnétorésistance géante est quasiment unipolaire, c'est-à-dire que deux champs magnétiques de même amplitude, mais de signes opposés, auront le même effet sur la résistance de la magnétorésistance géante et que la réponse au voisinage d'un champ magnétique nul est de pente quasiment nulle.

On voit d'après la figure 2 que lorsqu'une magnétorésistance géante est soumise à un champ magnétique proche de zéro, sa réponse est mal définie. Une magnétorésistance géante doit donc être polarisée par un champ de polarisation de façon à porter son point de fonctionnement dans la partie quasiment linéaire de la courbe. La plupart des composants dont la résistance et/ou l'inductance varie avec le champ magnétique auquel ils sont soumis nécessitent d'être portés en un point de fonctionnement adapté par un champ magnétique de polarisation. La figure 2 montre donc la nécessité de placer des moyens de polarisation 4.

Les moyens 3 pour mesurer un champ magnétique permettent la mesure d'une composante 7 du champ magnétique à mesurer 10. Du fait des flux magnétiques de polarisation 6, sur chaque branche de polarisation positive 2a on mesure un premier signal correspondant à la composante 7 du champ magnétique à mesurer 10 auquel on additionne un signal correspondant à un champ magnétique de polarisation, tandis que sur chaque branche de polarisation négative 2b on mesure un deuxième signal correspondant à la composante 7 du champ magnétique à mesurer 10 auquel on soustrait un signal correspondant à un champ magnétique de polarisation. Il y a donc plusieurs champs magnétiques de polarisation car le flux magnétique de polarisation total se répartit sur plusieurs branches dans l'exemple de la figure 1. Le flux magnétique de polarisation 6 n'est donc pas forcément le même sur chacune des branches. Les différents moyens 3 pour mesurer un champ magnétique ne mesurent donc pas forcément tous le même champ magnétique de polarisation. De même, on parle de plusieurs signaux correspondant à la composante 7 du champ magnétique à mesurer 10 car le flux magnétique correspondant à ladite composante 7 se répartit entre les branches, et ce de manière complexe. En mesurant un signal de sortie correspondant à la somme des signaux délivrés par chacun des moyens 3 pour mesurer un champ magnétique, au moins une partie des mesures de champs magnétiques de polarisation s'élimine.

Or, le champ magnétique de polarisation varie lors de mesures d'une composante 7 d'un champ magnétique à mesurer 10, notamment en raison de variations de l'alimentation 11 des moyens de polarisation 4. Ces variations induisent une grande incertitude sur la mesure de la composante 7 du champ magnétique à mesurer 10. Ainsi, cette incertitude diminue fortement si au moins une partie du champ magnétique de polarisation s'élimine. De préférence, il faut que la totalité du champ magnétique de polarisation s'élimine, ce qui dépend notamment des sections des branches 2a et 2b. En effet, un flux magnétique s'écoulant dans une branche 2a ou 2b, dépend de la surface de la section de cette branche 2a ou 2b, section perpendiculaire à la direction de propagation du flux magnétique. Ensuite, le champ magnétique correspondant à ce flux magnétique est fonction de ce flux magnétique. Il faut, pour que la totalité des flux magnétiques de polarisation 6 s'élimine, par exemple que la somme des sections des branches de polarisation positive 2a soit égale à la somme des sections des branches de polarisation négative 2b, et que sur chacune des branches 2a et 2b les moyens 3 pour mesurer un champ magnétique présentent une réponse à un champ magnétique identique et unipolaire. Il est donc possible d'éliminer, dans la mesure du signal de sortie, la totalité du flux magnétique de polarisation, en particulier avec des moyens 3 pour mesurer un champ magnétique identiques sur chacune des branches 2a et 2b.

La figure 4 présente un premier mode de réalisation d'un dispositif 1 selon l'invention. Ce mode de réalisation se compose d'un circuit magnétique en deux parties 12 en forme de U de 4 mm de large pour 10 mm de long, avec une section carré de 2mm par 2mm. Les deux parties 12 en forme de U sont assemblées de telle sorte qu'elles forment un circuit magnétique fermé, avec deux entrefers de largeur suffisante pour accueillir des moyens 3 pour mesurer un champ magnétique. Les deux entrefers sont de même largeur et les moyens 3 pour mesurer un champ magnétique sont situés pour chaque branche 2a et 2b au même emplacement dans l'entrefer. Les deux parties 12 en forme de U sont réalisées en un matériau ferromagnétique, plus précisément en ferrite, et peuvent aussi être composées d'un alliage magnétique comme le NiFe. La plus grande dimension des moyens 3 pour mesurer un champ magnétique est alignée avec les branches 2a et 2b des parties 12 en forme de U. Chaque partie 12 en forme de U est munie à sa base 5 d'une bobine constituant les moyens de polarisation 4. Chaque bobine est reliée à une alimentation 11 en courant alternatif. Les bobines induisent ainsi un champ magnétique de polarisation qui circule en boucle de la branche de polarisation positive 2a à la branche de polarisation négative 2b. Chacune des branches 2a et 2b est composée par une branche d'une des deux parties 12 en forme de U, des moyens 3 pour mesurer un champ magnétique, et une branche de l'autre partie 12 en forme de U. Les branches 2a et 2b se faisant face des deux parties 12 en forme de U sont espacées par deux entrefers, un sur la branche 2a de polarisation positive et un sur la branche 2b de polarisation négative. Plus l'entrefer est étroit, plus le champ magnétique est intense dans cet entrefer, ce qui améliore la précision de la mesure d'un champ magnétique par des moyens 3 pour mesurer un champ magnétique situés dans cet entrefer.

La figure 3 présente en détail les moyens 3 pour mesurer un champ magnétique mis en oeuvre dans le premier mode de réalisation du dispositif 1. Il s'agit de micro-capteurs proposés notamment par la société NVE sous la référence AA002, composés de quatre magnétorésistances géantes montées en pont de Wheatstone. On va considérer ici un pont de Wheatstone agencé en forme de carré dans lequel deux angles opposés sont correspondant respectivement à des bornes $A^+$ et $A^-$, et les deux autres angles opposés correspondent respectivement à des bornes $V^+$ et $V^-$. Deux magnétorésistances géantes 13 sont situées respectivement sur deux branches parallèles du carré, exposées à tout champ magnétique et identiques, l'une entre les bornes $A^+$ et $V^+$ et l'autre entre les bornes $A^-$ et $V^-$. Deux autres magnétorésistances géantes 14 sont situées respectivement sur les deux autres branches parallèles du carré, et sont sensiblement isolées de tout champ magnétique grâce à deux blindages 15 plats qui font aussi office de concentrateurs de flux pour tout champ magnétique à proximité, en particulier un champ magnétique auquel sont soumises les magnétorésistances géantes 13. Le pont de Wheatstone est alimenté par une tension continue $(V+ - V^-)$, et on mesure la différence de potentiel $(A^+ - A^-) = V^A$. On a alors sur la branche de polarisation positive 2a, sachant que la réponse des moyens 3 pour mesurer un champ magnétique est unipolaire :

$$V^{A+} = S.(Hpi + Hmi),$$

et

$$V^{A-} = -S.(Hpi + Hmi),$$

où Hpi est l'amplitude du champ de polarisation pour la branche de polarisation positive 2a, Hmi est l'amplitude de la composante 7 du champ à mesurer 10 selon l'axe des branches 2a et 2b et pour la branche de polarisation positive 2a, et S est la sensibilité des moyens 3 pour mesurer un champ magnétique, par exemple environ 3,5 mV/A/m ou 2,8 μV/nT. De plus, on a généralement |Hpi| largement supérieur à |Hmi|.

De même, on mesure sur la branche de polarisation négative 2b la différence de potentiel $(B^+ - B^-) = V^B$. On a alors sur la branche de polarisation négative 2b, compte tenu que les deux branches ont la même section entre elles et à proximité des moyens 3 pour mesurer un champ magnétique, et que la réponse des moyens 3 pour mesurer un champ magnétique est unipolaire :

$$V^{B+} = S*(Hpj - Hmj),$$

et

$$V^{B-} = -S*(Hpj - Hmj).$$

où Hpj est l'amplitude du champ de polarisation pour la branche de polarisation négative 2b, Hmj est l'amplitude de la composante 7 du champ à mesurer 10 selon l'axe des branches 2a et 2b et pour la branche de polarisation négative 2b, et généralement |Hpj| largement supérieur à |Hmj|.

Ici, comme les branches 2b et 2b sont identiques, on a Hpi=Hpj=Hp et Hmi=Hmj=Hm.

Sur la figure 4, un bloc de détection synchrone 15 est relié aux moyens 3 pour mesurer un champ magnétique, à la fois sur la branche de polarisation positive 2a et sur la branche de polarisation négative 2b. Les deux sorties des bloc de détection synchrone 15 passent chacune par une chaîne d'amplification, puis sont sommées grâce à un amplificateur opérationnel 16. Le bloc de détection synchrone 15 et les amplificateur constituent une électronique de conditionnement du signal de sortie. On obtient alors le signal de sortie $V^S = _V A - _V B = 4S*Hm$. On voit donc que Hp a complètement disparu des équations. On note ici que le calcul, bien que plus compliqué, est aussi envisageable dans le cas où on a plus de deux branches et où elles sont toutes différentes, et qu'on n'a alors pas la simplification Hmi=Hm $\forall i$ et Hpi=Hp $\forall i$, où à chaque indice i correspond des moyens 3 pour mesurer un champ magnétique.

Un autre avantage conféré par ce mode de réalisation est que $V^A$ et $V^B$ sont très proches, ce qui signifie que leur différence est proche de zéro, ainsi que l'influence des variations de l'alimentation 11 des moyens de polarisation 4.

On voit aussi sur la figure 4 deux bobines 17 dites bobines de contre-réaction. Chaque bobine compte environ 320 spires.

Le dispositif 1 selon ce mode de réalisation présente un encombrement de 30mm*15mm*6mm (épaisseur hors broches). L'électronique de conditionnement du signal de sortie, est réalisée sur une carte de circuit imprimé équipé de circuits CMS (composants montés en surface).

La figure 5 illustre un deuxième mode de réalisation du dispositif 1 compact dans lequel le dispositif 1 est fabriqué entièrement en technologie micro électronique sur le même substrat, par dépôt de couches minces pour le circuit magnétique et par procédé standard pour l'électronique de conditionnement du signal de sortie. L'électronique intégrée permet également une sortie du signal directement en numérique. Les branches 2a et 2b sont réalisées chacune en forme d'une couche de 10mm de longueur et de 2 mm de largeur, chacune comportant au milieu de leur longueur des moyens 3 pour mesurer un champ magnétique. Les moyens de polarisation 4 permettent de fermer le circuit de polarisation à chacune des extrémités des couches constituant les branches 2a et 2b. On voit donc que le dispositif selon l'invention présente des capacités de miniaturisation très fortes. L'encombrement est de l'ordre du cm$^2$ en surface, ici 0,2 cm$^2$, pour une épaisseur de l'ordre de 0,5 mm. Ce volume intègre les moyens 3 pour mesurer un champ magnétique, le circuit de polarisation jouant aussi le rôle de circuit d'amplification, ainsi que électronique de conditionnement du signal à mesurer.

La figure 6 illustre un système 20 de mesure vectorielle d'un champ magnétique à mesurer 10, mettant en oeuvre trois dispositifs 1 chacun orientés selon trois axes x, y et z formant une base d'un espace en trois dimensions. Grâce à chacun des trois dispositifs 1, on mesures Cx, Cy, Cz, c'est-à-dire les composantes du champs à mesurer 10 respectivement selon les axes x, y et z.

Bien sûr, l'invention n'est pas limitée aux exemples qui viennent d'être décrits et de nombreux aménagements peuvent être apportés à ces exemples sans sortir du cadre de l'invention. En particulier, les branches du dispositif ne sont pas forcement parallèles sur toute leur longueur, mais peuvent ne l'être qu'au voisinage des moyens pour mesurer un champ magnétique, d'autres composants et configurations pour les moyens pour mesurer un champ magnétique, d'autres moyens de polarisation, d'autres formes de circuits de polarisation en boucle que celles illustrées peuvent être mis en oeuvre.

**Revendications**

1. Dispositif (1) pour détecter et/ou mesurer un champ magnétique faible, comprenant au moins deux branches (2a, 2b) composées d'un matériau ferromagnétique, sensiblement parallèles entre elles selon leur plus grande dimension, chacune desdites branches (2a, 2b) étant munie de moyens (3) pour détecter et/ou mesurer un champ magnétique, et arrangée pour être parcourue par un flux magnétique de polarisation (6) de sorte qu'au moins deux desdites branches (2a, 2b) sont de polarisations de signes opposés, **caractérisé en ce qu'**au moins une des branches (2a, 2b) est munie d'au moins un entrefer où sont agencés des moyens (3) pour mesurer un champ magnétique.

2. Dispositif (1) selon les revendications 1, **caractérisé en ce qu'**il forme au moins une boucle fermée pour le flux magnétique de polarisation total.

3. Dispositif (1) selon l'une quelconque des revendications précédentes, **caractérisé en ce que** le flux magnétique de polarisation total se répartit à parts sensiblement égales entre l'au moins une branche de polarisation positive (2a) et l'au moins une branche de polarisation négative (2b).

4. Dispositif selon l'une quelconque des revendications précédentes, **caractérisé en ce que** les moyens (3) pour mesurer un champ magnétique appartenant à chacune des branches (2a, 2b) présentent les mêmes caractéristiques.

5. Dispositif (1) selon l'une quelconque des revendications précédentes, **caractérisé en ce que** les moyens (3) pour mesurer un champ magnétique sont à réponse sensiblement unipolaire.

6. Dispositif (1) selon l'une quelconque des revendications précédentes, **caractérisé en ce qu'**il comprend un nombre pair de branches (2a, 2b) de même section et **en ce que** les branches (2a, 2b) ont des polarisations de même amplitude et opposées deux à deux.

7. Dispositif (1) selon l'une quelconque des revendications précédentes, **caractérisé en ce que** les moyens (3) pour mesurer un champ magnétique comprennent au moins un composant dont la résistance dépend du champ magnétique auquel il est soumis.

8. Dispositif (1) selon l'une quelconque des revendications précédentes, **caractérisé en ce que** les moyens (3) pour mesurer un champ magnétique comprennent au moins un composant dont l'inductance dépend du champ magnétique auquel il est soumis.

9. Dispositif (1) selon l'une quelconque des revendications précédentes, **caractérisé en ce que** l'au moins un composant comprend au moins une magnétorésistance géante (13, 14), ou une magnétorésistance à effet tunnel, ou une magnétorésistance géante anisotropique.

10. Dispositif (1) selon l'une des revendication précédentes, **caractérisé en ce que** les moyens (3) pour mesurer un champ magnétique comprennent au moins deux composants, au moins l'un desdits composants étant isolé de tout champ magnétique par un blindage (15), et au moins l'un desdits composants étant soumis à tout champ magnétique

11. Dispositif (1) selon l'une quelconque des revendications précédentes, **caractérisé en ce que** les moyens (3) pour mesurer un champ magnétique comprennent quatre composants montés en pont de Wheatstone, au moins l'un desdits composants étant isolé de tout champ magnétique par un blindage (15), et au moins l'un desdits composants étant soumis à tout champ magnétique.

12. Dispositif (1) selon l'une quelconque des revendications précédentes, **caractérisé en ce que** des moyens de polarisation (4) induisent le champ magnétique de polarisation et comprennent au moins un élément parmi une bobine et un aimant permanent.

13. Dispositif (1) selon l'une quelconque des revendications précédentes, **caractérisé en ce que** chaque branche (2a, 2b) comprend au moins une contre-réaction (17).

14. Dispositif selon la revendication 13, **caractérisé en ce que** chacune des branches (2a, 2b) comprend le même nombre de contre-réactions (17).

15. Système pour détecter et/ou mesurer un champ magnétique faible **caractérisé en ce qu'**il comprend deux dispositifs (1) selon l'une quelconque des revendications précédentes, disposés selon deux axes formant une base d'un plan.

16. Système (20) pour détecter et/ou mesurer un champ magnétique faible **caractérisé en ce qu'**il comprend trois dispositifs (1) selon l'une quelconque des revendications 1 à 14, disposés selon trois axes (x, y, z) formant une base d'un espace en trois dimensions.

17. Dispositif (1) selon l'une quelconque des revendications 1 à 14 ou système (20) selon l'une des revendications 15 ou 16, destiné à la mesure d'un champ magnétique faible appliquée au secteur spatial.

**Patentansprüche**

1. Vorrichtung (1) zum Erfassen und/oder Messen eines schwachen Magnetfeldes, enthaltend zumindest zwei Schenkel (2a, 2b), die aus einem ferromagnetischen Material bestehen, mit ihrer größeren Abmessung im Wesentlichen parallel zueinander verlaufen, wobei jeder der Schenkel (2a, 2b) mit Mitteln (3) ausgestattet ist, um ein Magnetfeld zu erfassen und/oder zu messen, und dazu vorgesehen ist, von einem Magnetfluss (6) zur Polarisation durchflossen zu werden, so dass zumindest zwei der Schenkel (2a, 2b) mit entgegengesetzten Vorzeichen polarisiert werden, **dadurch gekennzeichnet, dass** zumindest einer der Schenkel (2a, 2b) mit zumindest einem Luftspalt versehen ist, wo Mittel (3) zum Messen eines Magnetfeldes angeordnet sind.

2. Vorrichtung (1) nach Anspruch 1, **dadurch gekennzeichnet, dass** sie zumindest einen geschlossenen Kreis für den gesamten Magnetfluss zur Polarisation bildet.

3. Vorrichtung (1) nach einem der vorangehenden Ansprüche, **dadurch gekennzeichnet, dass** der gesamte Magnetfluss zur Polarisation sich auf im Wesentlichen gleiche Teile zwischen dem zumindest einen Schenkel mit Nordpol-Polarisation (2a) und dem zumindest einen Schenkel mit Südpol-Polarisation (2b) aufteilt.

4. Vorrichtung nach einem der vorangehenden Ansprüche, **dadurch gekennzeichnet, dass** die Mittel (3) zum Messen eines Magnetfeldes, die zu jedem der Schenkel (2a, 2b) gehören, die gleichen Eigenschaften aufweisen.

5. Vorrichtung (1) nach einem der vorangehenden Ansprüche, **dadurch gekennzeichnet, dass** die Mittel (3) zum Messen eines Magnetfeldes im Wesentlichen unipolar reagieren.

6. Vorrichtung (1) nach einem der vorangehenden Ansprüche, **dadurch gekennzeichnet, dass** sie eine gerade Anzahl von Schenkeln (2a, 2b) gleichen Querschnitts aufweist und dass die Schenkel (2a, 2b) Polarisationen gleicher Amplitude paarweise entgegengesetzt haben.

7. Vorrichtung (1) nach einem der vorangehenden Ansprüche, **dadurch gekennzeichnet, dass** die Mittel (3) zum Messen eines Magnetfeldes zumindest eine Komponente aufweisen, deren Widerstand von dem Magnetfeld abhängt, dem sie ausgesetzt wird.

8. Vorrichtung (1) nach einem der vorangehenden Ansprüche, **dadurch gekennzeichnet, dass** die Mittel (3) zum Messen eines Magnetfeldes zumindest eine Komponente aufweisen, deren Induktivität von dem Magnetfeld abhängt, dem sie ausgesetzt wird.

9. Vorrichtung (1) nach einem der vorangehenden Ansprüche, **dadurch gekennzeichnet, dass** die zumindest eine Komponente zumindest einen Riesenmagnetowiderstand (13, 14) oder einen Magnetowiderstand mit Tunneleffekt oder einen anisotropen Riesenmagnetowiderstand aufweist.

10. Vorrichtung (1) nach einem der vorangehenden Ansprüche, **dadurch gekennzeichnet, dass** die Mittel (3) zum Messen eines Magnetfeldes zumindest zwei Komponenten enthalten, wobei zumindest eine der Komponenten durch eine Abschirmung (15) von jeglichem Magnetfeld isoliert ist und zumindest eine der Komponenten jeglichem Magnetfeld ausgesetzt ist.

**11.** Vorrichtung (1) nach einem der vorangehenden Ansprüche, **dadurch gekennzeichnet, dass** die Mittel (3) zum Messen eines Magnetfeldes vier Komponenten aufweisen, die als Wheatstone-Brücke geschaltet sind, wobei zumindest eine der Komponenten durch eine Abschirmung (15) von jeglichem Magnetfeld isoliert ist und zumindest eine der Komponenten jeglichem Magnetfeld ausgesetzt ist.

**12.** Vorrichtung (1) nach einem der vorangehenden Ansprüche, **dadurch gekennzeichnet, dass** Polarisationsmittel (4) das Magnetfeld zur Polarisation induzieren und zumindest eines der Elemente Spule bzw. Dauermagnet aufweisen.

**13.** Vorrichtung (1) nach einem der vorangehenden Ansprüche, **dadurch gekennzeichnet, dass** jeder Schenkel (2a, 2b) zumindest eine Gegenkopplung (17) aufweist.

**14.** Vorrichtung (1) nach Anspruch 13, **dadurch gekennzeichnet, dass** jeder der Schenkel (2a, 2b) die gleiche Anzahl an Gegenkopplungen (17) aufweist.

**15.** System zum Erfassen und/oder Messen eines schwachen Magnetfeldes, **dadurch gekennzeichnet, dass** es zwei Vorrichtungen (1) nach einem der vorangehenden Ansprüche aufweist, die entlang zweier Achsen angeordnet sind, die eine Grundfläche für eine Ebene bilden.

**16.** System (20) zum Erfassen und/oder Messen eines schwachen Magnetfeldes, **dadurch gekennzeichnet, dass** es drei Vorrichtungen (1) nach einem der Ansprüche 1 bis 14 aufweist, die entlang dreier Achsen (x, y, z) angeordnet sind, die eine Grundfläche für einen dreidimensionalen Raum bilden.

**17.** Vorrichtung (1) nach einem der Ansprüche 1 bis 14 oder System (20) nach einem der Ansprüche 15 oder 16, bestimmt für das Messen eines schwachen Magnetfeldes, das im Raumfahrtsektor Anwendung findet.

**Claims**

**1.** Device (1) for detecting and/or measuring a weak magnetic field, comprising at least two branches (2a, 2b) of a ferromagnetic material which are substantially mutually parallel along their longest dimension, each branch (2a, 2b) being provided with means (3) for detecting and/or measuring a magnetic field, and arranged so as to be traversed by a magnetic flux of polarisation (6) such that at least two of said branches (2a, 2b) are of opposite polarisations, **characterised in that** at least one of the branches (2a, 2b) is provided with at least one air gap, where means (3) for measuring a magnetic field are arranged.

**2.** Device (1) according to claim 1, **characterised in that** it forms at least one closed loop for the total magnetic flux of polarisation.

**3.** Device (1) according to any one of the preceding claims, **characterised in that** the total magnetic flux of polarisation is divided into substantially equal parts between the at least one positive polarisation branch (2a) and the at least one negative polarisation branch (2b).

**4.** Device according to any one of the preceding claims, **characterised in that** the means (3) for measuring a magnetic field belonging to each of the branches (2a, 2b) exhibit the same characteristics.

**5.** Device (1) according to any one of the preceding claims, **characterised in that** the means (3) for measuring a magnetic field have a substantially unipolar response.

**6.** Device (1) according to any one of the preceding claims, **characterised in that** it comprises an even number of branches (2a, 2b) of the same cross section and **in that** the branches (2a, 2b) have polarisations of the same amplitude and opposed in pairs.

**7.** Device (1) according to any one of the preceding claims, **characterised in that** the means (3) for measuring a magnetic field comprise at least one component, whose resistance depends on the magnetic field to which it is subjected.

**8.** Device (1) according to any one of the preceding claims, **characterised in that** the means (3) for measuring a magnetic field comprise at least one component, whose inductance depends on the magnetic field to which it is subjected.

**9.** Device (1) according to any one of the preceding claims, **characterised in that** the at least one component comprises at least one giant magneto resistance (13, 14), or a tunnel effect magneto resistance, or an anisotropic giant magneto resistance.

**10.** Device (1) according to any one of the preceding claims, **characterised in that** the means (3) for measuring a magnetic field comprise at least two components, at least one of said components being insulated from all magnetic fields by a shield (15), and at least one of said components being subjected to any magnetic field.

**11.** Device (1) according to any one of the preceding claims, **characterised in that** the means (3) for measuring a magnetic field comprise four components mounted as a Wheatstone bridge, at least one of said components being insulated from all magnetic fields by a shield (15), and at least one of said components being subjected to any magnetic field.

**12.** Device (1) according to any one of the preceding claims, **characterised in that** means of polarisation (4) induce the magnetic field of polarisation and comprise at least one element among a coil and a permanent magnet.

**13.** Device (1) according to any one of the preceding claims, **characterised in that** each branch (2a, 2b) comprises at least one feedback (17).

**14.** Device according to claim 13, **characterised in that** each of the branches (2a, 2b) comprises the same number of feedbacks (17).

**15.** System for detecting and/or measuring a weak magnetic field **characterised in that** it comprises two devices (1) according to any one of the preceding claims, arranged along two axes forming a base of a plane.

**16.** System (20) for detecting and/or measuring a weak magnetic field **characterised in that** it comprises three devices (1) according to any one of claims 1 to 14, arranged along three axes (x, y, z) forming a base of a three dimensional space.

**17.** Device (1) according to any one of claims 1 to 14 or system (20) according to one of claims 15 or 16, intended for the measurement in the space industry of a weak magnetic field.

## FIG. 1

## FIG. 2

## FIG. 3

## FIG. 4

## FIG. 5

## FIG. 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050035761 A1
- WO 2008016198 A1
- FR 2860594